(19) Europäisches Patentamt
European Patent Office
Office européen des brevets

(11) **EP 3 555 982 B1**

## (12) EUROPÄISCHE PATENTSCHRIFT

(45) Veröffentlichungstag und Bekanntmachung des Hinweises auf die Patenterteilung:
**27.04.2022  Patentblatt 2022/17**

(21) Anmeldenummer: **17825798.6**

(22) Anmeldetag: **15.12.2017**

(51) Internationale Patentklassifikation (IPC):
*H02H 1/04* (2006.01)   *H02H 3/05* (2006.01)
*H02H 3/093* (2006.01)   *H02H 3/44* (2006.01)

(52) Gemeinsame Patentklassifikation (CPC):
**H02H 1/04; G01R 19/16528; G01R 31/52; H02H 3/05; H02H 3/093;** G01R 19/16547; H02H 3/44

(86) Internationale Anmeldenummer:
**PCT/EP2017/083007**

(87) Internationale Veröffentlichungsnummer:
**WO 2018/109161 (21.06.2018 Gazette 2018/25)**

(54) **ÜBERSTROM- UND KURZSCHLUSSDETEKTOR**

OVERCURRENT AND SHORT CIRCUIT DETECTOR

DÉTECTEUR DE SURINTENSITÉ ET DE COURT-CIRCUIT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.12.2016  DE 102016124638**

(43) Veröffentlichungstag der Anmeldung:
**23.10.2019  Patentblatt 2019/43**

(73) Patentinhaber: **Eaton Intelligent Power Limited Dublin 4 (IE)**

(72) Erfinder: **HAUER, Wolfgang**
**4191 Vorderweissenbach (AT)**

(74) Vertreter: **Eaton IP Group**
**EMEA**
**c/o Eaton Industries Manufacturing GmbH**
**Route de la Longeraie 7**
**1110 Morges (CH)**

(56) Entgegenhaltungen:
EP-A2- 1 772 936    DE-B- 1 063 696
DE-C1- 19 729 599    US-A- 3 657 605
US-A- 3 970 901

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen Überstrom- und/oder Kurzschlussdetektor gemäß dem Oberbegriff des Patentanspruches 1.

Zur Überstrom- und/oder Kurzschlusserkennung sind sog. "2-D locus curves" zum Beispiel aus DE 197 29 599 C1 bekannt. Dabei wird neben einem Momentanwert des Stromes zu einem bestimmten Zeitpunkt weiters dessen erste Ableitung nach der Zeit in die Bewertung einbezogen. Weiters sind auch sog. "3-D locus curves" bekannt, bei welchen weiters die zweite Ableitung nach der Zeit in die Bewertung einbezogen wird.

Diese bekannten Algorithmen bzw. deren schaltungstechnischen Umsetzungen weisen den Nachteil auf, dass diese zu unnötigem Auslösen neigen, indem diese, an sich unproblematische Ereignisse bzw. Stromverläufe als Überstrom und/oder Kurzschlussstrom detektieren. Insbesondere bei kapazitiven Einschaltströmen bzw. anderen, insbesondere sehr steilen, Stromspitzen detektieren diese einen Überstrom und/oder Kurzschluss und verursachen eine unnötige Netzabschaltung. Derartige Netzabschaltungen können zur Unterbrechung von Produktionsprozessen und Datenverlusten führen. Weiters können diese aufwendige Service- bzw. Wartungsarbeiten verursachen, indem ein Elektriker die Ursache für diese Netzabschaltungen suchen wird, solche jedoch nicht finden kann, da die Ursache im Schutzschaltgerät liegt und das Netz und die angeschlossenen Geräte ansonsten in Ordnung sind. Dies kann auch zum Ersetzen betriebssicherer Geräte führen, sofern diese als vermeintliche Fehlerquelle identifiziert wurden.

Die US 3 970 901 zeigt eine Methode und eine Anordnung zur Kurzschlussdetektion.

Die US 3 657 605 beschreibt einen Überstrom-Auslöser, welche eine geringe Neigung zu Fehlauslösungen haben soll.

Die EP 1 772 936 A2 beschreibt einen Lichtbogendetektor.

Die DE 10 63 696 B bezieht sich auf eine Schutzschaltung gegen Überstrom für Wechselstromkreise und besteht darin, dass eine Einrichtung vorgesehen ist, durch die in jeder Halbwelle das zeitliche Integral des Stromes von seinem Nulldurchgang an gemessen wird, und die ein Kommando zur Auslösung eines den Strom unterbrechenden Schalters gibt, sobald das zeitliche Stromintegral im Verlauf einer Halbwelle einen vorgegebenen Wert überschreitet.

Aufgabe der Erfindung ist es daher einen Überstrom- und/oder Kurzschlussdetektor der eingangs genannten Art anzugeben, mit welchem die genannten Nachteile vermieden werden können, mit welchem eine sichere und gegen Fehlauslösungen stabile Überstrom- und/oder Kurzschlussdetektion möglich ist.

Erfindungsgemäß wird dies durch die Merkmale des Patentanspruches 1 erreicht. Dadurch kann eine Überstrom- und/oder Kurzschlussdetektion erfolgen, welche stabil gegen Fehldetektionen aufgrund transienter Vorgänge ist, welche Überströme und/oder Kurzschlüsse sicher erkennt, und welche einfach zu implementieren ist. Dadurch kann die Netzverfügbarkeit erhöht werden. Dadurch können die Aufwende für die Fehlersuche reduziert werden.

Die Erfindung betrifft weiters ein Schutzschaltgerät mit einem gegenständlichen Überstrom- und/oder Kurzschlussdetektor.

Die Erfindung betrifft weiters ein Verfahren zur Überstrom- und/oder Kurzschlussdetektion gemäß Patentanspruch 5, welches die vorstehend angeführte Aufgabe löst und die geltend gemachten Vorteile zur Folge hat.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:

Fig. 1 ein Blockschaltbild eines gegenständlichen Überstrom- und/oder Kurzschlussdetektors;

Fig. 2 ein Blockschaltbild eines gegenständlichen Schutzschaltgeräts; und

Fig. 3 eine schematische Darstellung eines Verlaufes eines gegenständlichen Wertepaares zusammen mit der grafisch dargestellten Grenzbedingung.

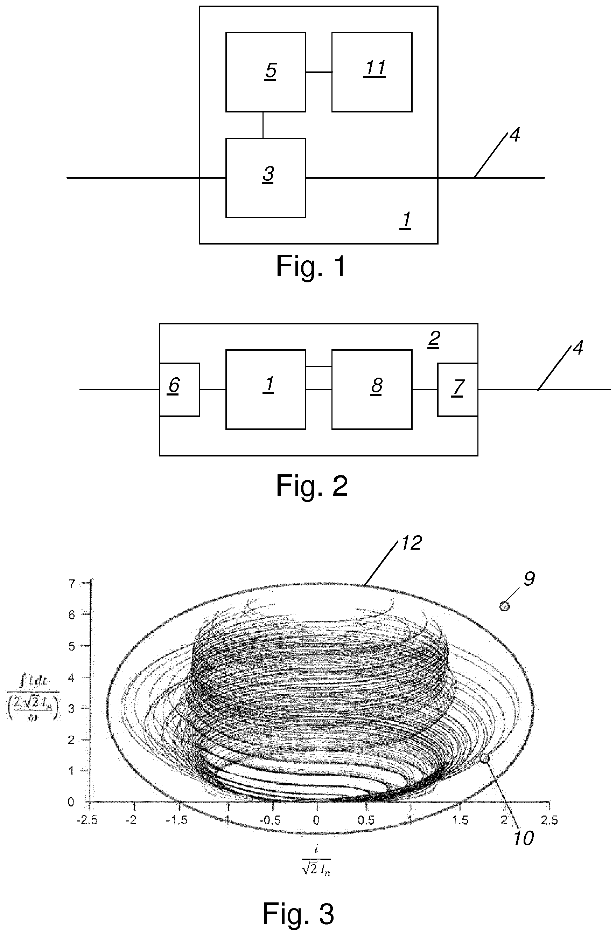

Die Fig. 1 zeigt einen Überstrom- und/oder Kurzschlussdetektor 1, insbesondere für ein Schutzschaltgerät 2, mit wenigstens einem Stromsensor 3 zur Aufnahme eines Stromsignals mit vorgebbarer Zeitauflösung in wenigstens einer elektrischen Stromstrecke 4, und wenigstens einer Auswerteeinheit 5.

Der Überstrom- und/oder Kurzschlussdetektor 1 ist für die Überwachung wenigstens einer elektrischen Stromstrecke 4 bzw. eines elektrischen Leiters vorgesehen. Insbesondere können auch Überstrom- und/oder Kurzschlussdetektoren 1 für eine vorgebbare Mehrzahl an elektrischen Stromstrecken 4 ausgebildet sein.

Je Stromstrecke weist der Überstrom- und/oder Kurzschlussdetektor 1 wenigstens einen Stromsensor 3 auf, welcher etwa umfassend einem Shunt, einem Hallsensor und/oder einer Förstersonde ausgebildet sein kann, oder aber als anderer Sensor. Der Stromsensor 3 ist dazu ausgebildet einen zeitlichen Stromverlauf aufzunehmen, und weist eine vorgebbare Zeitauflösung auf. Da gegenständlich eine Analyse des Zeitverhaltens des Stromes vorgesehen ist und transiente Vorgänge erfasst werden sollen, ist bevorzugt vorgesehen, dass der Stromsensor 3 eine zeitliche Auflösung von besser bzw. kleiner 125 μs, entsprechend einer Abtastrate von 8 kHz bei digitaler Ausführung des Stromsensors 3, aufweist. Besonders bevorzugt ist eine Abtastrate von wenigstens 20 kHz, entsprechend einer Zeitauflösung von 50 μs, vorgesehen.

Der Überstrom- und/oder Kurzschlussdetektor 1 weist weiters eine Auswerteeinheit 5 auf, welche mit dem Stromsensor 3 nachrichtentechnisch, insbesondere schaltungstechnisch, verbunden ist. Die Auswerteeinheit 5 ist bevorzugt umfassend einen Mikrocontroller ausgebildet, wobei jedoch auch vorgesehen sein kann, diese rein in Hardware bzw. mittels einer programmierbaren Logikschaltung auszubilden.

Die Auswerteeinheit 5 ist dazu ausgebildet, einen ersten Zeitpunkt eines vorgebbar steilen Anstieges des Stromsignals zu ermitteln. Dazu wird die entsprechende Ableitung gebildet, welche ein Maß für die Steilheit eines Anstiegs ist. Es wird also die sog. Slew Rate ermittelt. Die Steilheit des Anstiegs wird mit einem Grenzwert verglichen. Wenn die Steilheit des Anstiegs den Grenzwert übersteigt wird die Möglichkeit eines Überstromes und/oder Kurzschlusses als gegeben angesehen, und der Stromverlauf weiter analysiert. In diesem Fall wird mit dem Auftreten des möglichen Überstromes und/oder Kurzschlusses ein Timer gestartet. Der betreffende Zeitpunkt wird als erster Zeitpunkt definiert.

Die Auswerteeinheit 5 bildet nachfolgend das zeitliche Integral der Stromwerte des Stromsignals vom ersten Zeitpunkt bis zu einem, diesem nachfolgenden zweiten Zeitpunkt. Dabei ist bevorzugt vorgesehen, dass der zweite Zeitpunkt maximal eine Periodendauer einer anliegenden Netzfrequenz nach dem ersten Zeitpunkt liegt. Bei einer Netzfrequenz von 50 Hz liegt der zweite Zeitpunkt also maximal 20 ms nach dem ersten Zeitpunkt. Für ausgewählte Fälle kann die Spanne zwischen erstem und zweitem Zeitpunkt auch größer sein.

Die Auswerteeinheit 5 bildet das Integral ständig weiter. Der jeweilige Wert des Integrals nach Ablauf einer bestimmten Zeitdauer wird dabei zusammen mit dem Wert des Stromsignals, zu der betreffenden Zeitdauer zu einem Wertepaar vereinigt. Dieses Wertepaar wird durch die Auswerteeinheit 5 mit wenigstens einer vorgebbaren Grenzbedingung verglichen.

Die Bildung des Wertepaares und deren Vergleich mit der Grenzbedingung erfolgt bevorzugt im Wesentlichen kontinuierlich, wobei insbesondere vorgesehen ist, dass dieser Vergleich entsprechend der Samplingrate des Stromsensors 3 erfolgt.

Fig. 3 zeigt eine grafische Darstellung möglicher Werte des Wertepaares. Die dabei eingetragene Kurvenschar entsprechend der Darstellung eines Wirbelsturmes besteht aus einer Vielzahl von Kurven, wobei jede der Kurven, welche jeweils eine sog. Locus Curve ist, einen möglichen Stromverlauf darstellt. Da sich die betreffenden Einzelkurven jeweils innerhalb der umrandenden Ellipse befinden, handelt es sich dabei auch um erlaubte bzw. zulässige Stromverläufe.

In Fig. 3 ist auf der X-Achse der Stromwert i zu einem bestimmten Zeitpunkt normiert auf einen Scheitelwert des Nennstroms $I_N$ einer zu überwachenden Anlage, etwa 16 A, aufgetragen. Auf der Y-Achse ist jedoch das Integral des jeweiligen Stromwertes i, normiert auf das Integral des Nennstromes $I_N$ über eine Sinuswelle aufgetragen, wobei ω in an sich bekannter Weise die Netzfrequenz ist.

Die Grenzbedingung lautet insbesondere wie folgt:

$$(\smallint i - y_0)^2/a^2 + (i - x_0)^2/b^2 \leq 1$$

Diese Gleichung definiert eine Ellipse 12. Dies ist in Fig. 3 eingetragen.

Beim Vergleich des Wertepaares mit der Grenzbedingung wird also ermittelt, ob sich das Wertepaar, grafisch betrachtet, innerhalb oder außerhalb der Ellipse befindet. Befindet sich das Wertepaar während der Dauer des möglichen Überstrom- und/oder Kurzschlussereignisses stets innerhalb der Ellipse bzw. Grenzbedingung so liegt kein Überstrom und/oder Kurzschluss vor. Bezugszeichen 10 stellt ein Beispiel für ein solches Wertepaar dar, bei dem ein Überstrom und/oder Kurzschluss nicht vorlag. Sobald das Wertepaar jedoch die Ellipse verlässt und derart die Grenzbedingung verletzt bzw. nicht mehr erfüllt, liegt ein Überstrom und/oder Kurzschluss vor. Bezugszeichen 9 stellt ein Beispiel für ein solches Wertepaar dar, bei dem ein Kurzschluss vorlag.

Bei einem Überschreiten bzw. einer Verletzung der Grenzbedingung durch das Wertepaar, daher durch die Kombination aus beiden Werten, ist vorgesehen, dass der Überstrom- und/oder Kurzschlussdetektor 1 eine Überstrom- und/oder Kurzschlussmeldung an einem Ausgang 11 des Überstrom- und/oder Kurzschlussdetektors 1 ausgibt. Hiezu ist die Auswerteeinheit 5 mit dem Ausgang 11 verbunden. Der Ausgang 11 selbst kann sowohl elektrisch als auch mechanisch ausgeführt sein.

Bei einem Verfahren zur Überstrom- und/oder Kurzschlussdetektion ist entsprechend vorgesehen ein Stromsignal mit vorgebbarer Zeitauflösung in einer elektrischen Stromstrecke 4 aufzunehmen, wobei nachfolgend:

- ein erster Zeitpunkt eines vorgebbar steilen Anstieges des Stromsignals ermittelt wird, wobei
- ein zeitliches Integral der Stromwerte des Stromsignals vom ersten Zeitpunkt bis zu einem zweiten Zeitpunkt gebildet wird, wobei
- in vorgebbaren zeitlichen Abständen, insbesondere im Wesentlichen kontinuierlich, ein Wertepaar, bestehend aus einem jeweiligen Wert des Integrals und dem jeweiligen Wert des Stromsignals, mit wenigstens einer vorgebbaren Grenzbedingung verglichen wird, und wobei
- bei einem Überschreiten der Grenzbedingung durch das Wertepaar eine Überstrom- und/oder Kurzschlussmeldung ausgegeben wird.

Hinsichtlich bevorzugter Ausführungsmerkmale der einzelnen Verfahrensschritte sind die entsprechenden Ausführungen zum Überstrom- und/oder Kurzschlussdetektor 1 anzuwenden.

Fig. 2 zeigt ein Blockschaltbild eines Schutzschaltgeräts 2. Dabei ist lediglich eine einzige elektrische Stromstrecke 4 von einem ersten Anschluss 6 des Schutzschaltgeräts 2 zu einem zweiten Anschluss 7 des Schutzschaltgeräts 2 dargestellt, wobei das Schutzschaltgeräts 2 auch eine größere Anzahl an Stromstrecken 4 und Anschlüssen 6, 7 aufweisen kann.

Es ist vorgesehen, dass das Schutzschaltgerät 2 einen gegenständlichen Überstrom-und/oder Kurzschlussdetektor 1 aufweist. Das Schutzschaltgerät 2 ist dazu ausgebildet, nach einer Überstrom- und/oder Kurzschlussmeldung des Überstrom-und/oder Kurzschlussdetektors 1 die Stromstrecke 4 zu unterbrechen. Hiezu weist das Schutzschaltgerät 2 eine entsprechende Unterbrechungseinheit 8 auf, welche mittels Schaltschloss und mechanischen Kontakten, mittels hybrider Schalttechnologie bzw. als reiner Solid State Unterbrecher ausgebildet sein kann.

Der Überstrom- und/oder Kurzschlussdetektor 1 ist mit der Unterbrechungseinheit 8 verbunden.

## Patentansprüche

1. Überstrom- und/oder Kurzschlussdetektor (1), insbesondere für ein Schutzschaltgerät (2), mit wenigstens einem Stromsensor (3) zur Aufnahme eines Stromsignals mit vorgebbarer Zeitauflösung in wenigstens einer elektrischen Stromstrecke (4), und wenigstens einer Auswerteeinheit (5), wobei die Auswerteeinheit (5) dazu ausgebildet ist einen ersten Zeitpunkt eines vorgebbar steilen Anstieges des Stromsignals zu ermitteln, **dadurch gekennzeichnet, dass** die Auswerteeinheit (5) dazu ausgebildet ist:

   - ein zeitliches Integral der Stromwerte des Stromsignals vom ersten Zeitpunkt bis zu einem zweiten Zeitpunkt zu bilden, und
   - in vorgebbaren zeitlichen Abständen, insbesondere im Wesentlichen kontinuierlich, ein Wertepaar, bestehend aus einem jeweiligen Wert des Integrals, $i$, und dem jeweiligen Wert des Stromsignals, i, mit wenigstens einer vorgebbaren Grenzbedingung zu vergleichen, und
   - bei einem Überschreiten der Grenzbedingung durch das Wertepaar eine Überstrom- und/oder Kurzschlussmeldung an einem Ausgang (11) des Überstrom- und/oder Kurzschlussdetektors (1) auszugeben.

2. Überstrom- und/oder Kurzschlussdetektor (1) nach Anspruch 1, **dadurch gekennzeichnet, dass** der zweite Zeitpunkt maximal eine Periodendauer einer anliegenden Netzfrequenz nach dem ersten Zeitpunkt liegt.

3. Überstrom- und/oder Kurzschlussdetektor (1) nach Anspruch 1, **dadurch gekennzeichnet, dass** die Grenzbedingungen: $(i - y_0)^2/a^2 + (i - x_0)^2/b^2 \leq 1$ lautet, wobei diese Gleichung eine Ellipse definiert.

4. Schutzschaltgerät (2) mit wenigstens einer elektrischen Stromstrecke (4) von einem ersten Anschluss (6) des Schutzschaltgeräts (2) zu einem zweiten Anschluss (7) des Schutzschaltgeräts (2), **dadurch gekennzeichnet, dass** das Schutzschaltgerät (2) einen Überstrom- und/oder Kurzschlussdetektor (1) nach einem der Ansprüche 1 bis 3 aufweist, und dass das Schutzschaltgerät (2) ausgebildet ist, nach einer Überstrom- und/oder Kurzschlussmeldung des Überstrom- und/oder Kurzschlussdetektors (1) die Stromstrecke (4) zu unterbrechen.

5. Verfahren zur Überstrom- und/oder Kurzschlussdetektion, wobei ein Stromsignal mit vorgebbarer Zeitauflösung in einer elektrischen Stromstrecke (4) aufgenommen wird, wobei

   - ein erster Zeitpunkt eines vorgebbar steilen Anstieges des Stromsignals ermittelt wird, **dadurch gekennzeichnet, dass**
   - ein zeitliches Integral der Stromwerte des Stromsignals vom ersten Zeitpunkt bis zu einem zweiten Zeitpunkt gebildet wird, dass
   - in vorgebbaren zeitlichen Abständen, insbesondere im Wesentlichen kontinuierlich, ein Wertepaar, bestehend aus einem jeweiligen Wert des Integrals und dem jeweiligen Wert des Stromsignals, mit wenigstens einer vorgebbaren Grenzbedingung verglichen wird, und dass
   - bei einem Überschreiten der Grenzbedingung durch das Wertepaar eine Überstrom- und/oder Kurzschlussmeldung ausgegeben wird.

## Claims

1. Overcurrent and/or short-circuit detector (1), in particular for a protective switching device (2), having at least one current sensor (3) for recording a current signal with a predeterminable time resolution in at least one electrical current path (4), and at least one evaluation unit (5), the evaluation unit (5) being designed to determine a first point in time of a predeterminable steep increase in the current signal, **characterized in that** the evaluation unit (5) is designed:

   - to form a time integral of the current values of the current signal from the first point in time to a second point in time, and

- to compare a pair of values, consisting of a relevant value of the integral, $\int i$, and the relevant value of the current signal, i, with at least one predeterminable limit condition at predeterminable time intervals, in particular substantially continuously, and

- outputting an overcurrent and/or short circuit message at an output (11) of the overcurrent and/or short circuit detector (1) if the limit condition is exceeded by the pair of values.

2. Overcurrent and/or short-circuit detector (1) according to claim 1, **characterized in that** the second point in time is at most one period of an applied mains frequency after the first point in time.

3. Overcurrent and/or short-circuit detector (1) according to claim 1, **characterized in that** the boundary conditions are: $(\int i - y_0)^2/a^2 + (i - x_0)^2/b^2 \leq 1$, with this equation defining an ellipse.

4. Protective switching device (2) having at least one electrical current path (4) from a first connection (6) of the protective switching device (2) to a second connection (7) of the protective switching device (2), **characterized in that** the protective switching device (2) has an overcurrent and/or short-circuit detector (1) according to any of claims 1 to 3, and **in that** the protective switching device (2) is designed to interrupt the current path (4) after an overcurrent and/or short-circuit message from the overcurrent and/or short-circuit detector (1).

5. Method for overcurrent and/or short-circuit detection, a current signal with a predeterminable time resolution in an electrical current path (4) being recorded, where

- a first point in time of a predeterminable steep increase in the current signal is determined, **characterized in that**
- a time integral of the current values of the current signal is formed from the first point in time to a second point in time, **in that**
- a pair of values, consisting of a relevant value of the integral and the relevant value of the current signal, is compared with at least one predeterminable limit condition at predeterminable time intervals, in particular substantially continuously, and **in that**
- if the limit condition is exceeded by the pair of values, an overcurrent and/or short-circuit message is output.

**Revendications**

1. Détecteur de surintensité et/ou de court-circuit (1), en particulier destiné à un commutateur de protection (2), comportant au moins un capteur de courant (3) permettant d'enregistrer un signal de courant avec une résolution temporelle prédéfinissable dans au moins un trajet de courant (4) électrique, et au moins une unité d'évaluation (5), l'unité d'évaluation (5) étant configurée pour déterminer un premier instant d'une forte augmentation prédéfinissable du signal de courant, **caractérisé en ce que** l'unité d'évaluation (5) est configurée pour :

- former une intégrale temporelle des valeurs de courant du signal de courant du premier instant à un second instant, et
- comparer, à des intervalles de temps prédéfinissables, en particulier de manière sensiblement continue, une paire de valeurs constituée d'une valeur respective de l'intégrale, $\int i$ et de la valeur respective du signal de courant, i, à au moins une condition limite prédéfinissable, et
- délivrer un message de surintensité et/ou de court-circuit à une sortie (11) du détecteur de surintensité et/ou de court-circuit (1) si la condition limite est dépassée par la paire de valeurs.

2. Détecteur de surintensité et/ou de court-circuit (1) selon la revendication 1, **caractérisé en ce que** le second instant se situe au plus à une durée de période d'une fréquence de réseau appliquée après le premier instant.

3. Détecteur de surintensité et/ou de court-circuit (1) selon la revendication 1, **caractérisé en ce que** les conditions limites sont : $(\int i - y_0)^2/a^2 + (i - x_0)^2/b^2 \leq 1$, ladite équation définissant une ellipse.

4. Commutateur de protection (2) comportant au moins un trajet de courant (4) électrique d'un premier raccord (6) du commutateur de protection (2) à un second raccord (7) du commutateur de protection (2), **caractérisé en ce que** le commutateur de protection (2) présente un détecteur de surintensité et/ou de court-circuit (1) selon l'une des revendications 1 à 3, et que le commutateur de protection (2) est conçu pour interrompre le trajet de courant (4) après un message de surintensité et/ou de court-circuit du détecteur de surintensité et/ou de court-circuit (1).

5. Procédé permettant la détection de surintensité et/ou de court-circuit, dans lequel un signal de courant avec une résolution temporelle prédéfinissable est enregistré dans un trajet de courant (4) électrique,

- un premier instant d'une forte augmentation prédéfinissable du signal de courant étant déterminé, **caractérisé en ce que**

- une intégrale temporelle des valeurs de courant du signal de courant est formée du premier instant à un second instant, que

- une paire de valeurs, constituée d'une valeur respective de l'intégrale et de la valeur respective du signal de courant, est comparée à au moins une condition limite prédéfinissable à des intervalles de temps prédéfinissables, en particulier de manière sensiblement continue, et que

- si la condition limite est dépassée par la paire de valeurs, un message de surintensité et/ou de court-circuit est émis.

Fig. 1

Fig. 2

Fig. 3

**IN DER BESCHREIBUNG AUFGEFÜHRTE DOKUMENTE**

**In der Beschreibung aufgeführte Patentdokumente**

- DE 19729599 C1
- US 3970901 A
- US 3657605 A
- EP 1772936 A2
- DE 1063696 B